# EUROPEAN PATENT APPLICATION

(11) **EP 2 654 079 A2**
(43) Date of publication of application: **23.10.2013**
(21) Application number: 13162857.0
(22) Date of filing: 09.04.2013
(51) Int. Cl.: H01L 23/373, H01L 23/473

(54) **Heat dissipation device and method for manufacturing the same**

(30) Priority: 19.04.2012 JP 2012095485
(71) Applicant: Kabushiki Kaisha Toyota Jidoshokki, Kariya-shi, Aichi 448-8671 (JP); Showa Denko K.K., Tokyo 105-8518 (JP)
(72) Inventor: Iwata, Yoshitaka, Kariya-shi, Aichi 448-8671 (JP); Mori, Shogo, Kariya-shi, Aichi 448-8671 (JP); Minami, Kazuhiko, Oyama-shi, Tochigi 323-8678 (JP); Hirano, Tomoya, Oyama-shi, Tochigi 323-8678 (JP)
(74) Representative: TBK

(57) **Abstract**

A heat dissipation device includes an insulating substrate, a metal layer connected to the insulating substrate via a first brazing filler material, a stress relaxation member connected to the insulating substrate via a second brazing filler material, and a cooler connected to the stress relaxation member via a third brazing filler material. The stress relaxation member has one or more stress relaxation spaces each including an opening that is open to at least one of a face side and a back side of the stress relaxation member. At least one of the second and third brazing filler materials has one or more through-holes. Each through-hole includes an opening overlapped with the opening of the stress relaxation space or with the opening of a corresponding one of the stress relaxation spaces, and an edge of each through-hole opening is located externally to an edge of the corresponding stress relaxation space opening.

## Description

### BACKGROUND OF THE INVENTION

The present invention relates to a heat dissipation device and a method for manufacturing the device.

A structure in which a stress relaxation member is located between a heat sink and an insulating substrate is known. For example, refer to Japanese Laid-Open Patent Publication No. 2007-173405. The joint strength between the heat sink and the insulating substrate against a heat cycle is improved by providing the stress relaxation member between the heat sink and the insulating substrate.

In particular, in a semiconductor module as disclosed in the above-mentioned publication, a metal face plate is joined to a face side, which serves as a mounting surface, for semiconductor devices of a ceramics board, a metal back plate is joined to a back side of the substrate, and a heat dissipation device is joined to the metal back plate. The ceramics board is formed from aluminum nitride and each of the metal face plate and the metal back plate is formed from aluminum. A joint region and a non-joint region are formed in a joint face side of the metal back plate as the stress relaxation member joined to the heat dissipation device. The area of the joint region is set within a range of 65% to 85% of the area of the entire joint face side.

According to the above-mentioned semiconductor module, the non-joint region is formed in the metal back plate for jointing the ceramics board with the heat dissipation device so that thermal stress of the joint region is dispersed even when the thermal stress is generated due to a difference of linear thermal expansion coefficients of the ceramics board, the metal back plate, and the heat dissipation device. As a result, the stress is relaxed. For this reason, warping or cracks are prevented from being generated so that heat dissipation performance is maintained. In a case in which the non-joint region is formed, the area of the joint region is set within a range of 65% to 85% of the whole area of the joint face side to obtain an excellent heat dissipation performance, while relaxing thermal stress in a favorable manner, while taking into consideration a balance between the relaxation of the thermal stress and the hear dissipation performance.

In a case of brazing the stress relaxation member, when a brazing filler material foil is used, the brazing filler material can enter the through-holes formed in the stress relaxation member. This is likely to reduce the effect of stress relaxation.

### SUMMARY OF THE INVENTION

An object of the present invention is to provide a heat dissipation device and a method for manufacturing the heat dissipation device that can braze a stress relaxation member without reducing effect of stress relaxation of the stress relaxation member.

According to an aspect of the present invention a heat dissipation device including: an insulating substrate having a face side and a back side; a metal layer connected to the face side of the insulating substrate; a stress relaxation member connected to the back side of the insulating substrate; and a cooler connected to the back side of the stress relaxation member is provided. A semiconductor device can be joined to the metal layer. The stress relaxation member includes a face side, a back side, and one or more stress relaxation spaces. Each stress relaxation space includes an opening that is open to at least one of the face side and the back side of the stress relaxation member. The stress relaxation member is formed from aluminum with purity greater than or equal to 99.99% by weight. The insulating substrate and the metal layer are connected with each other by a first brazing filler material. The insulating substrate and the stress relaxation member are connected with each other by a second brazing filler material. The stress relaxation member and the cooler are connected with each other by a third brazing filler material. At least one of the second brazing filler material and the third brazing filler material has one or more through-holes. Each through-hole includes an opening that is overlapped with the opening of the stress relaxation space or with the opening of a corresponding one of the stress relaxation spaces, and an edge of each through-hole opening is located externally to an edge of the corresponding stress relaxation space opening.

According to the above-mentioned configuration, at least one of the second brazing filler material and the third brazing filler material has each through-hole overlapped with the stress relaxation space opening in a state in which an edge of the opening in each of the second brazing filler material and the third brazing filler material is located externally to an edge of the corresponding stress relaxation space opening. Accordingly, the brazing filler material is restricted from entering the stress relaxation spaces that are open to at least one of the face side and the back side when brazing. Thereby, the stress relaxation member can be brazed without reducing the stress relaxation effect of the stress relaxation member.

In accordance with another aspect of the present invention, a method for manufacturing a heat dissipation device including an arrangement step and a connection step is provided. In the arrangement step, a metal layer, a first brazing filler material, an insulating substrate, a second brazing filler material, a stress relaxation member, a third brazing filler material, and a cooler are arranged. The metal layer is arranged on a face side of the insulating substrate via the first brazing filler material. The stress relaxation member has one or more stress relaxation spaces. Each stress relaxation space includes an opening that is open to at least one of a face side and a back side of the stress relaxation member. The stress relaxation member is formed from aluminum with purity greater than or equal to 99.99% by weight. The second brazing filler material is arranged between the face side of the stress relaxation member and the back side of the insulating substrate. The third brazing filler material is arranged between the back side of the stress relaxation member and the cooler. At least one of the second brazing filler material and the third brazing filler material has one or more through-holes. Each through-hole of the third brazing filler material includes an opening, and at least one of the second brazing filler material and the third brazing filler material is arranged such that each through-hole opening is overlapped with the opening of the stress relaxation space or with the opening of a corresponding one of the stress relaxation spaces. An edge of each through-hole opening of the third brazing filler material is located externally to an edge of the corresponding stress relaxation space opening. In the connection step, the insulating substrate, the metal layer, the stress relaxation member, and the cooler are connected. The insulating substrate and the metal layer are connected with each other by melting the first brazing filler material. The stress relaxation member and the insulating substrate are connected with each other by melting the second brazing filler material. The stress relaxation member and the cooler are connected with each other by melting the third brazing filler material.

Other aspects and advantages of the present invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a vertical cross-sectional view showing a semiconductor module including a heat dissipation device according to one embodiment;
Fig. 2 is an exploded cross-sectional view showing the semiconductor module in Fig. 1;
Fig. 3A is a plan view showing a stress relaxation member;
Fig. 3B is a vertical cross-sectional view taken along line 3B-3B of Fig. 3A, showing the stress relaxation member;
Fig. 4A is a plan view showing a brazing filler material;
Fig. 4B is a vertical cross-sectional view taken along line 4B-4B of Fig. 4A, showing the brazing filler material;
Fig. 5 is a vertical cross-sectional view illustrating the procedures for manufacturing the semiconductor module;
Fig. 6 is an enlarged view showing an important section of an interface between the stress relaxation member and the brazing filler material;
Fig. 7 is an enlarged view showing an important section of the interface between the stress relaxation member and the brazing filler material according to another embodiment;
Fig. 8 is a vertical cross-sectional view showing a semiconductor module according to another embodiment;
Fig. 9 is an enlarged view showing an important section of the interface between the stress relaxation member and the brazing filler material according to another embodiment;
Fig. 10 is an exploded cross-sectional view showing a semiconductor module for comparison;
Fig. 11A is a plan view showing the stress relaxation member and the brazing filler material for comparison;
Fig. 11B is a vertical cross-sectional view taken along line 11B-11B of Fig. 11A, showing the stress relaxation member and the brazing filler material; and
Figs. 12A and 12B are partial enlarged views showing a stress relaxation member.

### DETAILED DESCRIPTION OF THE PREFERRED EMBODIMENTS

A heat dissipation device and a method for manufacturing the heat dissipation device according to one embodiment will now be described with reference to the drawings.

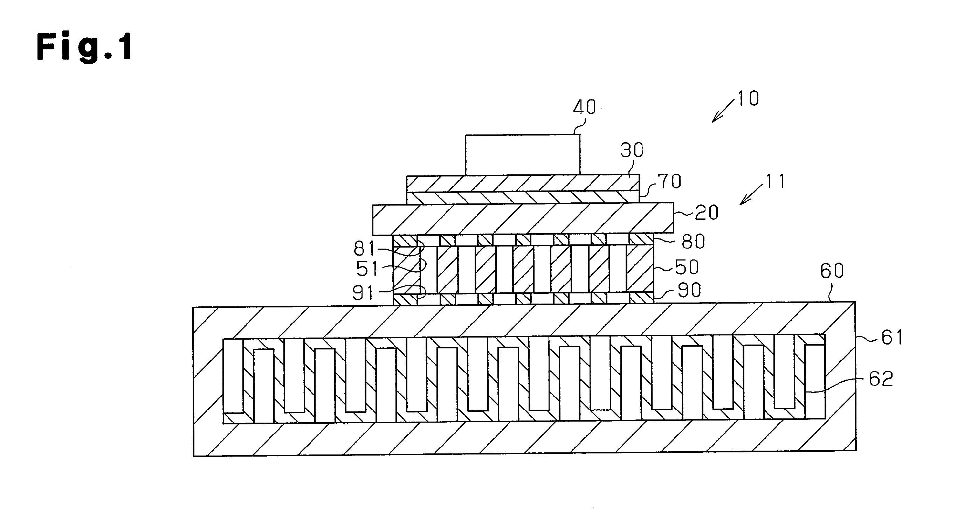

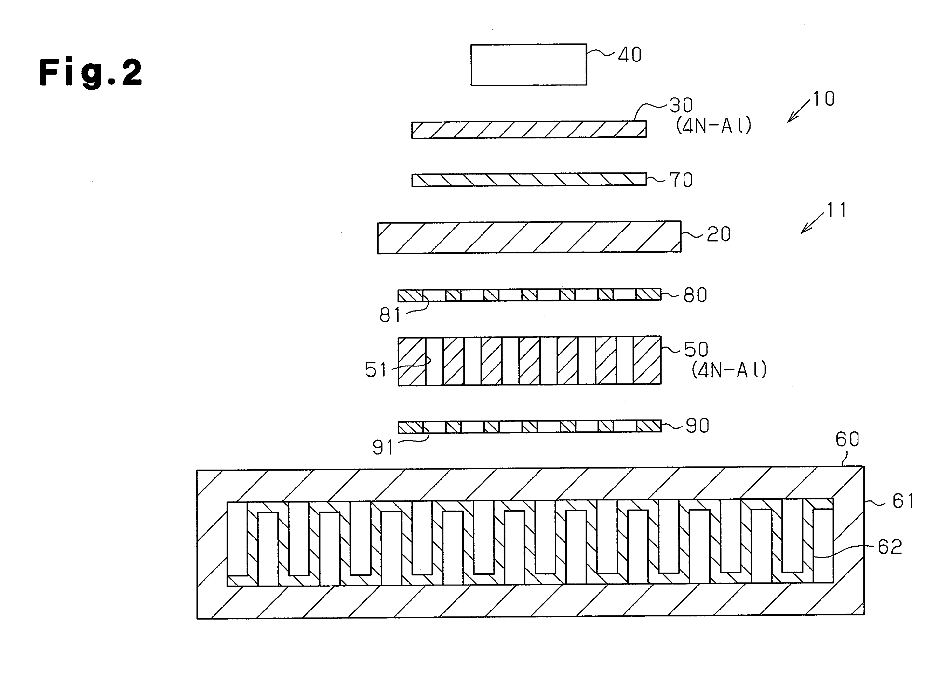

As shown in Figs. 1 and 2, a semiconductor module 10 includes a heat dissipation device 11 that cools a heat generating semiconductor device 40. The heat dissipation device 11 is suitable for cooling a power device as the semiconductor device 40, for example, insulated gate bipolar transistor (IGBT). More specifically, the heat dissipation device 11 is preferable for cooling the power device such as the IGBT used in a power converter mounted on electric circuits of an electric vehicle, a hybrid car, and a train. The heat dissipation device 11 has an insulating substrate 20, a metal layer 30, a stress relaxation member 50, and a cooler (heat sink) 60. The metal layer 30 can be joined to the semiconductor device 40.

The insulating substrate 20 is configured by a ceramics board. The metal layer 30 is configured by an aluminum layer formed from aluminum with purity of 99.99% by weight (4N: four nines). The metal layer 30 is connected to a face side (upper surface) of the insulating substrate 20.

The semiconductor device 40 is a chip of a power device. The semiconductor device 40 is connected to a face side (upper surface) of the metal layer 30 by soldering. Electrodes of the semiconductor device 40 are connected to the metal layer 30, and the metal layer 30 functions as a wiring layer of the electrodes.

The stress relaxation member 50 is configured by a plate material, and is connected to a back side (lower surface) of the insulating substrate 20. The stress relaxation member 50 is formed from aluminum with purity of 99.99% by weight (4N).

The cooler 60 is provided with a flat container 61 made from aluminum, and a partition plate 62 formed of a corrugated thin plate material. The partition plate 62 is arranged in the container 61 made from aluminum. The cooler 60 is configured such that cooling fluid passes through space in the container 61 made from aluminum. The cooler 60 is connected to a back side (lower surface) of the stress relaxation member 50.

The insulating substrate 20 and the metal layer 30 are connected with each other by a first brazing filler material (aluminum brazing filler material) 70. The insulating substrate 20 and the stress relaxation member 50 are connected with each other by a second brazing filler material (aluminum brazing filler material) 80. The stress relaxation member 50 and the cooler 60 are connected with each other by a third brazing filler material (aluminum brazing filler material) 90. Each of the first brazing filler material 70, the second brazing filler material 80, and the third brazing filler material 90 is brazing filler material foil, and has a thickness of about several tens of micrometers, for example, a thickness less than or equal to 50 µm.

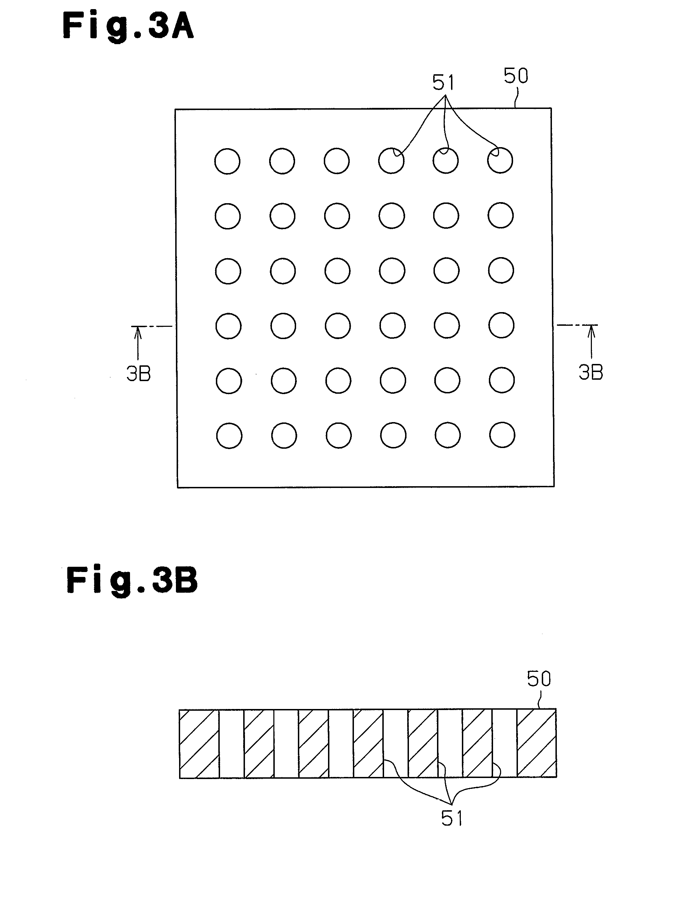

As shown in Figs. 3A and 3B, a plurality of through-holes 51 with circular cross-sectional shapes is formed in the stress relaxation member 50. The stress relaxation member 50 has stress relaxation spaces that are open to the face side (upper surface) and the back side (lower surface) thereof. That is, the stress relaxation spaces that are the through-holes 51 extending in a face side-back side direction, i.e., a thickness direction.

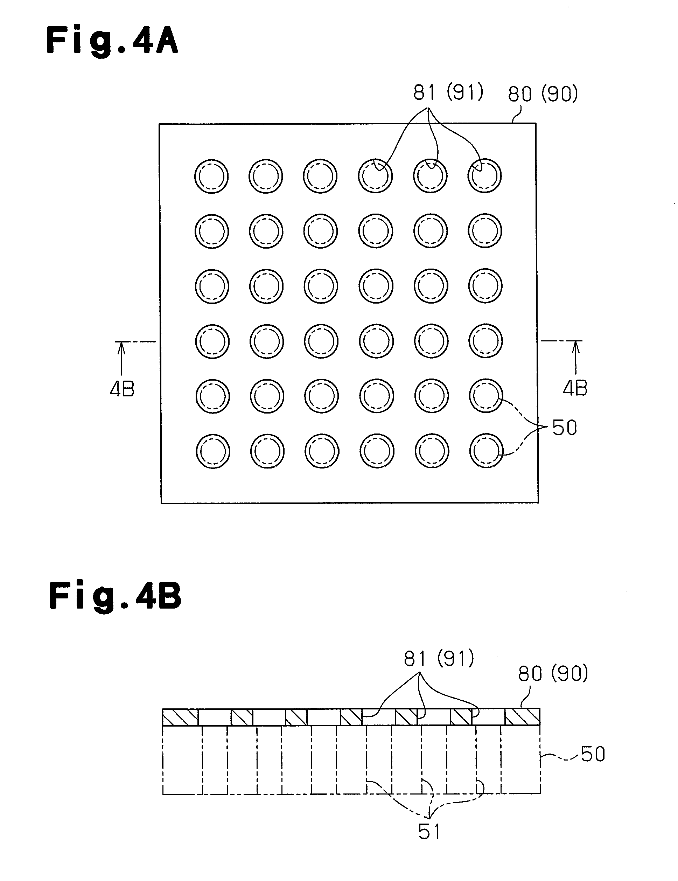

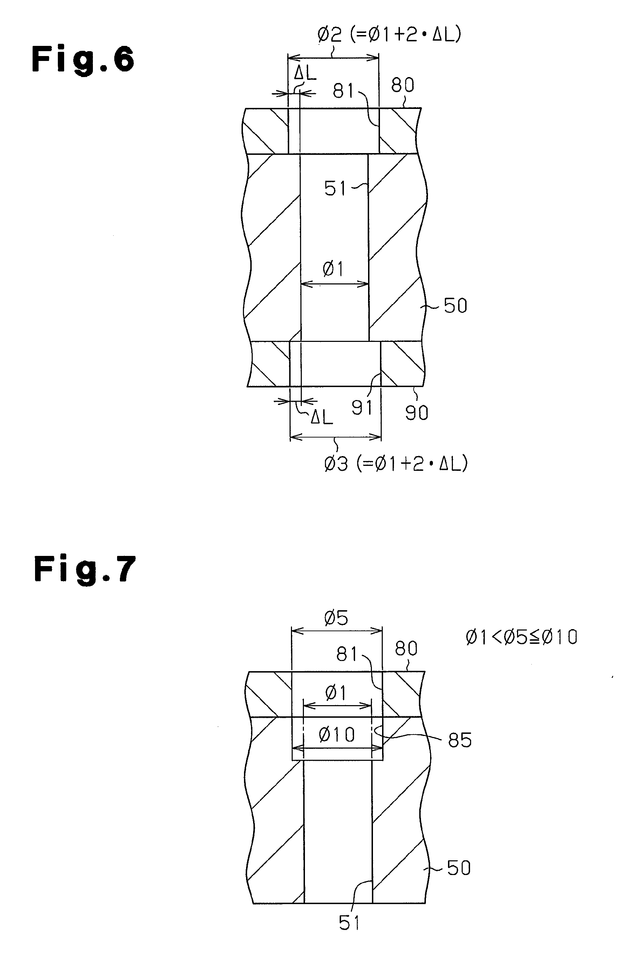

As shown in Figs. 4A and 4B, the second brazing filler material 80 has a plurality of through-holes 81 with circular cross-sectional shapes. Each through-hole 81 is overlapped with an upper side opening of a corresponding one of the through-holes (stress relaxation space) 51 of the stress relaxation member 50 in a state in which the edge of the through-hole 81 is located externally to the edge of the upper opening of the through-hole 51. More specifically, as shown in Fig. 6, each through-hole 81 is overlapped with the corresponding through-hole 51 in a state in which the center of the through-hole 51 in the stress relaxation member 50 corresponds to the center of the through-hole 81 in the second brazing filler material 80. The diameter ϕ2 of the through-hole 81 in the second brazing filler material 80 is set greater than the diameter ϕ1 of the through-hole 51 in the stress relaxation member 50 by a predetermined value ΔL (namely, ϕ2 = ϕ1 + 2·ΔL).

Similarly, the third brazing filler material 90 has a plurality of through-holes 91 with circular cross-sectional shapes. Each through-hole 91 is overlapped with a lower side opening of a corresponding one of the through-holes (stress relaxation spaces) 51 in the stress relaxation member 50 in a state in which the edge of the through-hole 91 is located externally to the edge of the lower opening of the through-hole 51. More specifically, each through-hole 91 is overlapped with the corresponding through-hole 51 in a state in which the center of the through-hole 51 in the stress relaxation member 50 corresponds to the center of a corresponding one of the through-holes 91 in the third brazing filler material 90. The diameter ϕ3 of the through-hole 91 in the third brazing filler material 90 is set greater than the diameter ϕ1 of the through-hole 51 in the stress relaxation member 50 by a predetermined value ΔL (namely, ϕ3 = ϕ1 + 2·ΔL).

Next, operations of the semiconductor module 10 (heat dissipation device 11) will now be described.

The semiconductor device 40 generates heat according to actuation. The heat generated by the semiconductor device 40 is conducted to the cooler 60 via the insulating substrate 20 and the stress relaxation member 50. The heat is transferred, namely, emitted by cooling fluid flowing in the container 61 made from aluminum of the cooler 60.

Further, when the temperature of an operating environment of the semiconductor module 10 changes, thermal stress is generated due to the difference between the thermal expansion coefficients of the insulating substrate 20 and the cooler 60. Since the stress of the heat cycle is relaxed by the stress relaxation member 50 including the through-holes 51, the junction strength between the insulating substrate 20 and the cooler 60 is improved.

Next, a method for manufacturing the semiconductor module 10 (heat dissipation device 11) will now be described.

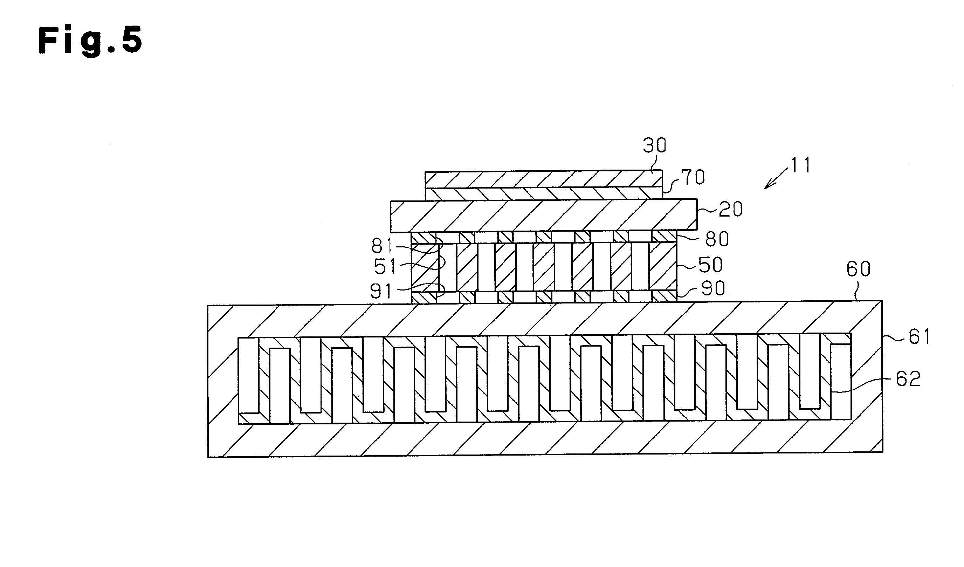

First, as shown in Fig. 5, the metal layer 30 is arranged on the face side of the insulating substrate 20 via the first brazing filler material 70. The second brazing filler material 80 including the through-holes 81 is arranged between the face side of the stress relaxation member 50 and the back side of the insulating substrate 20. The stress relaxation member 50 has the through-holes 51 as stress relaxation spaces that are open to the face side and the back side thereof and is formed from aluminum with purity of 4N. The third brazing filler material 90 including the through-holes 91 is arranged between the back side of the stress relaxation member 50 and the cooler 60.

At this time, as shown in Fig. 6, each through-hole 51 is overlapped with the corresponding through-hole 81 in a state in which the center of the through-hole 51 in the stress relaxation member 50 is aligned with the center of the through-hole 81 in the second brazing filler material 80. The size of the through-hole 81 in the second brazing filler material 80 is greater than the size of the through-hole 51 in the stress relaxation member 50. Similarly, each through-hole 51 is overlapped with the corresponding through-hole 91 in a state in which the center of the through-hole 51 in the stress relaxation member 50 is aligned with the center of the through-hole 91 in the third brazing filler material 90. The size of the through-hole 91 in the third brazing filler material 90 is greater than the size of the through-hole 51 in the stress relaxation member 50. At this time, each of the through-holes 81 and 91 formed in the second brazing filler material 80 and the third brazing filler material 90 is arranged such that it is overlapped with the opening of the corresponding through-hole 51 in the stress relaxation member 50 and the edge of the opening of each of the through-holes 81 and 91 is located externally to the edge of the opening of the through-hole 51.

Such a layered body is put on a base and pressed by a pressing plate from above.

In such a state, under a temperature environment of about 600°C, the first brazing filler material 70 is melted to connect the insulating substrate 20 and the metal layer 30 with each other. The second brazing filler material 80 is melted to connect the stress relaxation member 50 and the insulating substrate 20 with each other. The third brazing filler material 90 is melted to connect the stress relaxation member 50 to the cooler 60.

In this manner, the heat dissipation device 11 is manufactured.

Then, as shown in Fig. 1, the semiconductor device 40 is connected to the face side of the metal layer 30 by soldering.

In the semiconductor module 10 (heat dissipation device 11) manufactured as above described, the second brazing filler material 80 and the third brazing filler material 90 have through-holes 81 and 91 greater than the through-holes 51 in the stress relaxation member 50, respectively. Thereby, the brazing filler material is prevented from entering the through-holes 51 in the stress relaxation member 50 so that buffering effect is maintained.

Next, advantages will now be described in detail.

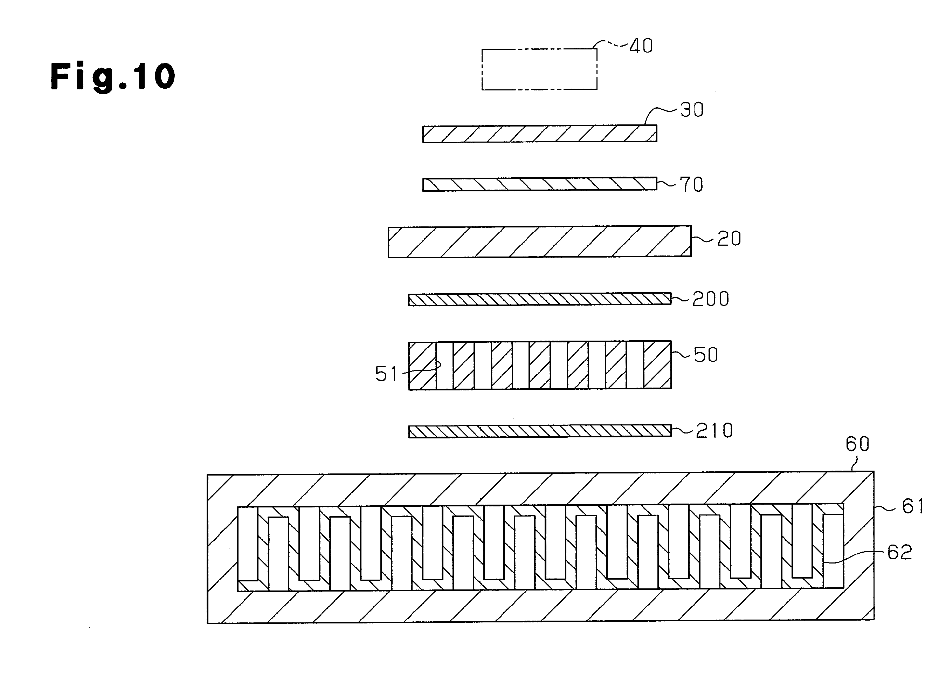

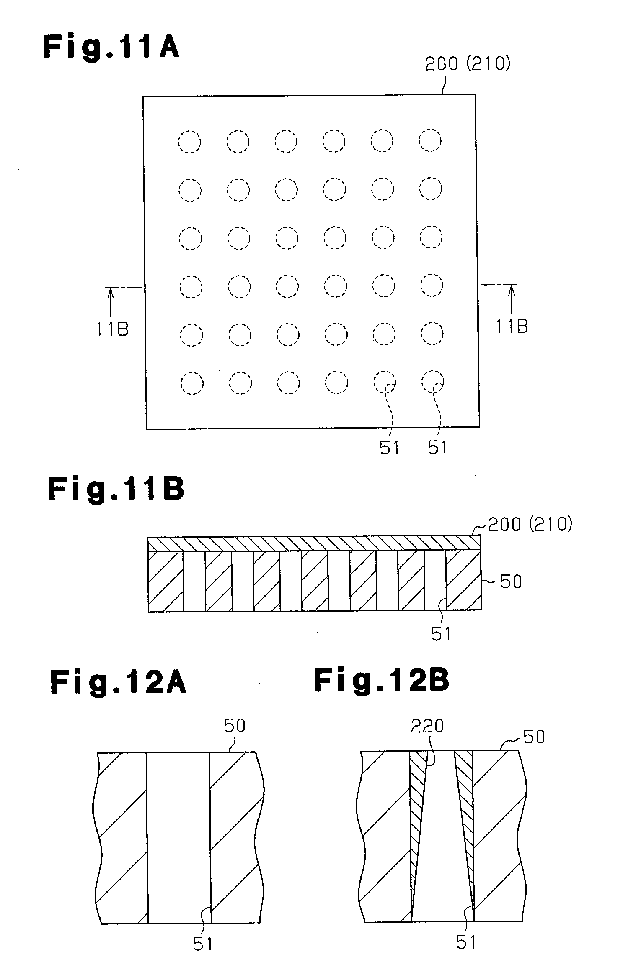

As shown in Fig. 10, as a comparative example of the present embodiment, a case is considered in which brazing filler material foils 200 and 210 are used when brazing the stress relaxation member 50. At this time, as shown in Figs. 11A and 11B, the brazing filler material foils 200 and 210 are the same with each other.

Fig. 12A shows the state prior to brazing. Then, through brazing, the brazing filler material 220 enter the through-hole 51 formed in the stress relaxation member 50 so that the through-hole 51 becomes narrower as shown in Fig. 12B. Due to this, stress relaxation effect is reduced.

In contrast, in the present embodiment, as shown in Fig. 6, the through-holes 81 and 91 with diameters greater than that of the through-hole 51 in a plan view are formed in the second brazing filler material 80 and the third brazing filler material 90, respectively. Thereby, the brazing filler materials are restricted from entering the through-holes 51 as the stress relaxation spaces that are open to the face side and the back side during brazing. As a result, the stress relaxation member 50 can be brazed without reducing the stress relaxation effect of the stress relaxation member 50.

As described above, the present embodiment has the following advantages.
(1) In the heat dissipation device 11, the second brazing filler material 80 and the third brazing filler material 90 have through-holes 81 and 91 overlapped with the openings of the through-holes 51 in the stress relaxation member 50 in a state in which each of the edges of the through-holes 81 and 91 is located externally to the edge of the opening of the through-hole 51. Thereby, the stress relaxation member 50 can be brazed without reducing the stress relaxation effect of the stress relaxation member 50.

In particular, when an aluminum plate with purity of 2N (two nines) is used as the stress relaxation member, a clad material with a face side on which the brazing filler material is formed can be used. When an aluminum plate with purity of 4N is used as the stress relaxation member, however, the clad material with the face side on which the brazing filler material is formed cannot be used. That is, since both of the 2N-aluminum plate and the brazing filler material are hard, the 2N-aluminum plate and the brazing filler material can configure the clad material by rolling the 2N-aluminum plate and the brazing filler material in a state in which they are laminated with each other. Since the 4N-aluminum plate is softer than the 2N-aluminum plate and has an extension coefficient greatly different from that of the brazing filler material, however, a joint state of the 4N-aluminum plate with respect to the brazing filler material cannot be maintained even if they are rolled in a state in which they are laminated.

In the present embodiment, the brazing can be performed by preparing and laminating an additional brazing filler material with respect to the 4N-aluminum plate without using the clad material.
(2) As for the second brazing filler material 80 arranged between the stress relaxation member 50 and the insulating substrate 20, since the insulating substrate 20 has low wettability with respect to the brazing filler material, it is easy for the melted brazing filler material to enter the through-holes 51 in the stress relaxation member 50. In this case, it is useful to prevent the brazing filler material from entering the through-holes 51 in the stress relaxation member 50 by forming the through-holes 81 in the second brazing filler material 80.
(3) As for the third brazing filler material 90 arranged between the stress relaxation member 50 and the cooler 60, it is easy for the melted brazing filler material to enter the through-holes 51 in the stress relaxation member 50 due to capillary action (surface tension). In this case, it is useful to prevent the brazing filler material from entering the through-holes 51 in the stress relaxation member 50 by forming the through-holes 91 in the third brazing filler material 90.
(4) The manufacturing method of the heat dissipation device includes an arrangement step and a connection step. In the arrangement step, the metal layer 30 is arranged on the face side of the insulating substrate 20 via the first brazing filler material 70. Further, the second brazing filler material 80 is arranged between the face side of the stress relaxation member 50 and the back side of the insulating substrate 20. The stress relaxation member 50 includes the through-holes 51 and is formed from aluminum with purity of 99.99% by weight. Further, the third brazing filler material 90 is arranged between the back side of the stress relaxation member 50 and the cooler 60. At this time, each of the through-holes 81 and 91 formed in the second brazing filler material 80 and the third brazing filler material 90, respectively is arranged such that it is overlapped with the opening of the corresponding through-hole 51 in the stress relaxation member 50 and the edge of the opening of each of the through-holes 81 and 91 is located externally to the edge of the opening of the through-hole 51. In the connection step, the first brazing filler material 70 is melted to connect the insulating substrate 20 and the metal layer 30 with each other. The second brazing filler material 80 is melted to connect the stress relaxation member 50 and the insulating substrate 20 with each other. The third brazing filler material 90 can be melted to connect the stress relaxation member 50 and the cooler 60 with each other.

Accordingly, the second brazing filler material 80 is arranged between the face side of the stress relaxation member 50 and the back side of the insulating substrate 20. Further, the third brazing filler material 90 is arranged between the back side of the stress relaxation member 50 and the cooler 60. At this time, each of the through-holes 81 and 91 formed in the second brazing filler material 80 and the third brazing filler material 90, respectively is arranged such that it is overlapped with the opening of the corresponding through-hole 51 as the stress relaxation space and the edge of the opening of each of the through-holes 81 and 91 is located externally to the edge of the opening of the through-hole 51. Accordingly, the brazing filler materials are restricted from entering the through-holes 51 as the stress relaxation spaces that are open to the face side and the back side when brazing. Thereby, the stress relaxation member 50 can be brazed without reducing the stress relaxation effect of the stress relaxation member 50.
(5) Since the amount of excess brazing filler material, which does not contribute to jointing and tries to enter the through-holes 51, can be reduced, wastes of the brazing filler material is reduced.

The embodiment is not limited to the above illustrated form but may be modified as follows, for example.

In the above-mentioned embodiment, the through-holes 81 are formed in the second brazing filler material 80 arranged between the stress relaxation member 50 and the insulating substrate 20, and the through-holes 91 are formed in the third brazing filler material 90 arranged between the stress relaxation member 50 and the cooler 60. However, only the through-holes 81 may be formed in the second brazing filler material 80 arranged between the stress relaxation member 50 and the insulating substrate 20. Alternatively, only the through-holes 91 may be formed in the third brazing filler material 90 arranged between the stress relaxation member 50 and the cooler 60.

In short, at least one of the second brazing filler material and the third brazing filler material may have through-holes overlapped with the openings of the stress relaxation space in a state in which the edge of the opening in each of the second brazing filler material and the third brazing filler material is located externally to the edge of the opening of the corresponding stress relaxation space.

In the arrangement step in the manufacturing method of the heat dissipation device 11, the second brazing filler material is arranged between the face side of the stress relaxation member and the back side of the insulating substrate. Further, the third brazing filler material is arranged between the back side of the stress relaxation member and the cooler. At this time, each of the through-holes formed in at least one of the second brazing filler material and the third brazing filler material may be arranged such that it is overlapped with the opening of the corresponding stress relaxation space and the edge of the opening of each of the through-holes is located externally to the edge of the opening of the corresponding stress relaxation space.

As shown in Fig. 7, pool portions 85 for the brazing filler material (brazing filler pools) may be formed in the openings of the through-holes 51 in the stress relaxation member 50. At this time, it is preferable to set the diameter ϕ5 of the through-holes 81 in the second brazing filler material 80 less than or equal to that of the diameter ϕ10 of the pool portions 85 for the brazing filler material in the stress relaxation member 50 and greater than that of the diameter ϕ1 of the through-holes 51 in the stress relaxation member 50.

Similarly, a configuration in Fig. 7 as above mentioned may be applied to the openings in the through-holes 51 in the stress relaxation member 50 facing with the third brazing filler material 90. That is, pool portions for the brazing filler material (brazing filler pools) may be formed in the openings in the stress relaxation member 50 facing with the third brazing filler material 90. At this time, it is preferable to set a value of the diameter of the through-holes 91 in the third brazing filler material 90 less than or equal to that of the diameter of the pool portions for the brazing filler material in the stress relaxation member 50 and greater than that of the diameter ϕ1 of the through-holes 51 in the stress relaxation member 50.

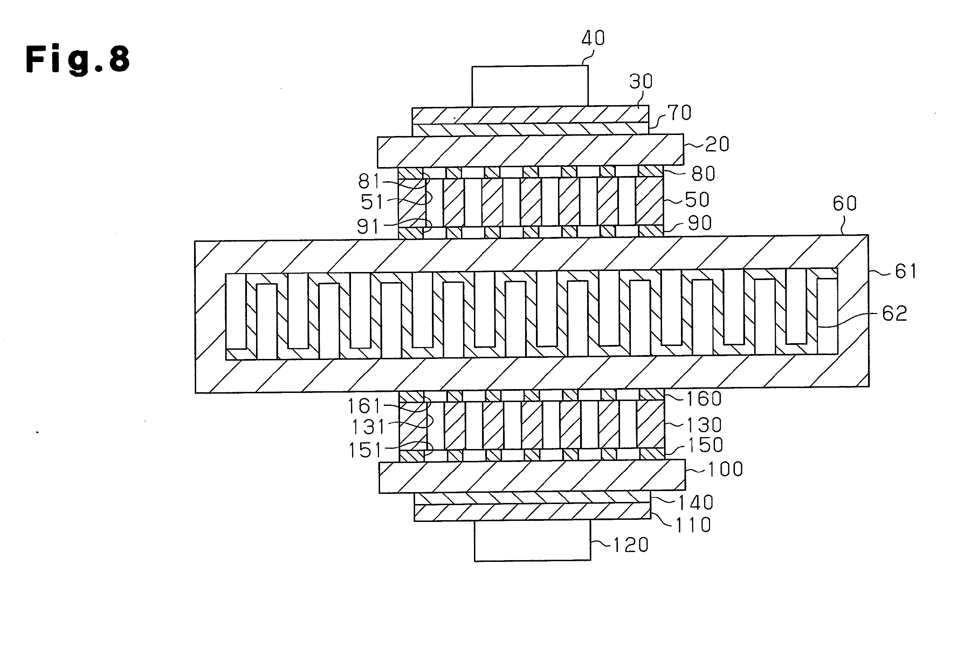

As shown in Fig. 8, the heat dissipation device may further include an insulating substrate (second insulating substrate) 100, a second metal layer 110 and a stress relaxation member (second stress relaxation member) 130. That is, a layered body configured by the insulating substrate (second insulating substrate) 100, the second metal layer 110 and the stress relaxation member (second stress relaxation member) 130, for example, may be arranged on a lower surface of the cooler 60 as well as on the upper surface of the cooler 60. The second metal layer 110 can be joined to a heat generating semiconductor device (second semiconductor device) 120. That is, the second insulating substrate 100 is located on the lower surface of the cooler 60, which is different from a portion in the cooler 60 connected to the stress relaxation member 50.

In Fig. 8, the second metal layer 110 is connected to a face side (lower surface) of the second insulating substrate 100. The second semiconductor device 120 is connected to a face side (lower surface) of the second metal layer 110 by soldering. The second stress relaxation member 130 has through-holes 131 as the stress relaxation spaces that are open to the face side and the back side thereof and is connected to a back side (upper surface) of the second insulating substrate 100 and to the cooler 60. The second stress relaxation member 130 is formed from aluminum with purity of 99.99% by weight (4N). The second insulating substrate 100 and the second metal layer 110 are connected with each other by a fourth brazing filler material 140. The second insulating substrate 100 and the second stress relaxation member 130 are connected with each other by a fifth brazing filler material 150. The second stress relaxation member 130 and the cooler 60 are connected with each other by a sixth brazing filler material 160. The fifth brazing filler material 150 and the sixth brazing filler material 160 have through-holes 151 and 161 overlapped with openings of the through-holes 131 in a state in which each of edges of the through-holes 151 and 161 is located externally to an edge of the opening of the corresponding through-hole (stress relaxation space) 131. Each of the through-holes 151 and 161 is overlapped with the corresponding through-hole 131 in the second stress relaxation member 130 in a state in which the center of each of the through-holes 131 is aligned with the center of each of the corresponding one of the through-holes 151 and 161. The diameter of the opening of each of the through-holes 151 and 161 is greater than the diameter of the opening of the corresponding through-hole 131.

Accordingly, the brazing filler materials are restricted from entering the through-holes 131 as the stress relaxation spaces that are open to the face side and the back side during brazing. Thereby, the second stress relaxation member 130 can be brazed without reducing the stress relaxation effect of the second stress relaxation member 130.

In this case, only the fifth brazing filler material 150 may have through-holes 151 overlapped with the openings of the through-holes 131 in a state in which each of edges of the openings of the through-holes 151 is located externally to the edge of the opening of the corresponding through-hole (stress relaxation space) 131. Alternatively, only the sixth brazing filler material 160 may have through-holes 161 overlapped with the openings of the through-holes 131 in a state in which each of edges of the openings of the through-holes 161 is located externally to the edge of the opening of the corresponding through-hole (stress relaxation space) 131. In short, at least one of the fifth brazing filler material and the sixth brazing filler material may have through-holes overlapped with the openings of the stress relaxation space in a state in which the edge of the opening in each of the fifth brazing filler material and the sixth brazing filler material is located externally to the edge of the opening of the corresponding stress relaxation space.

As for the method for manufacturing the heat dissipation device, in the arrangement step, the second metal layer 110 is arranged on the face side of the second insulating substrate 100 via the fourth brazing filler material 140. The second stress relaxation member 130 has the stress relaxation spaces (through-holes 131) that are open to at least one of the face side and the back side thereof and is formed from aluminum with purity greater than or equal to 99.99% by weight. Further, in the arrangement step, the fifth brazing filler material 150 is arranged between the face side of the second stress relaxation member 130 and the back side of the second insulating substrate 100. Moreover, the sixth brazing filler material 160 is arranged between the back side of the second stress relaxation member 130 and the cooler 60. At this time, each of the through-holes (151 and 161) formed in at least one of the fifth brazing filler material 150 and the sixth brazing filler material 160 is arranged such that it is overlapped with the opening of the corresponding stress relaxation space (through-hole 131) in the second stress relaxation member 130 and the edge of the opening of each of the through-holes (151 and 161) is located externally to the edge of the opening of the corresponding stress relaxation space (through-hole 131). Further, in the connection step, the fourth brazing filler material 140 is melted to connect the second insulating substrate 100 and the second metal layer 110 with each other. The fifth brazing filler material 150 is melted to connect the second stress relaxation member 130 and the second insulating substrate 100 with each other. The sixth brazing filler material 160 is melted to connect the second stress relaxation member 130 and the cooler 60 with each other.

Accordingly, the fifth brazing filler material 150 is arranged between the face side of the second stress relaxation member 130 and the back side of the second insulating substrate 100. Further, the sixth brazing filler material 160 is arranged between the back side of the second stress relaxation member 130 and the cooler 60. At this time, each of the through-holes (151 and 161) formed in at least one of the fifth brazing filler material 150 and the sixth brazing filler material 160 is arranged such that it is overlapped with the opening of the corresponding stress relaxation space (through-hole 131) and the edge of the opening of each of the through-holes (151 and 161) is located externally to the edge of the opening of the corresponding stress relaxation space (through-hole 131). Accordingly, the brazing filler material can be restricted from entering the stress relaxation spaces that are open to at least one of the face side and the back side when brazing. Thereby, the second stress relaxation member 130 can be brazed without reducing the stress relaxation effect of the second stress relaxation member 130.

The stress relaxation members 50 and 130 may be from, for example, aluminum with purity of 99.999% by weight (5N: five nines) or aluminum with purity of 99.9999% by weight (6N: six nines). In short, the stress relaxation member may be from aluminum with purity greater than or equal to 99.99% by weight.

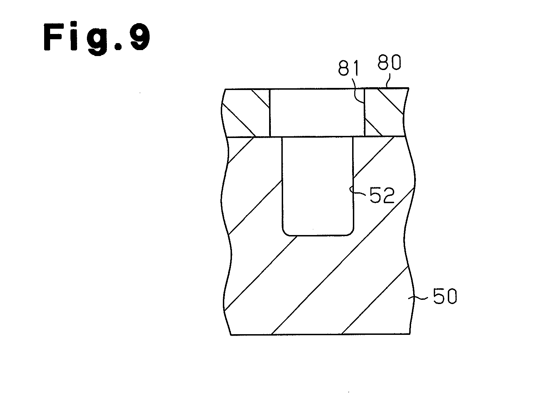

In the above-mentioned embodiment, the through-holes 51 and 131 as the stress relaxation space are formed in the stress relaxation members 50 and 130. Alternatively, as shown in Fig. 9, a recess 52 as the stress relaxation space may be formed in the stress relaxation member 50. The recess 52 is a recessed portion that does not extend through the stress relaxation member 50. Alternatively, the recess (52) may be formed in the stress relaxation member 130 as in Fig. 9. In short, the stress relaxation members (50, 130) may have the stress relaxation spaces that are open to at least one of the face side and the back side.

The stress relaxation member 50 may be formed from materials other than the aluminum, for example, copper.

In the method for manufacturing the heat dissipation device, in the embodiment of Fig. 1, components of the insulating substrate 20, the metal layer 30, the stress relaxation member 50, and the cooler 60 are arranged in this order. The order of arranging the components, however, can be arbitrarily changed.

Therefore, the present examples and embodiments are to be considered as illustrative and not restrictive and the invention is not to be limited to the details given herein, but may be modified within the scope and equivalence of the appended claims.

A heat dissipation device includes an insulating substrate, a metal layer connected to the insulating substrate via a first brazing filler material, a stress relaxation member connected to the insulating substrate via a second brazing filler material, and a cooler connected to the stress relaxation member via a third brazing filler material. The stress relaxation member has one or more stress relaxation spaces each including an opening that is open to at least one of a face side and a back side of the stress relaxation member. At least one of the second and third brazing filler materials has one or more through-holes. Each through-hole includes an opening overlapped with the opening of the stress relaxation space or with the opening of a corresponding one of the stress relaxation spaces, and an edge of each through-hole opening is located externally to an edge of the corresponding stress relaxation space opening.

## Claims

1. A heat dissipation device, comprising:
an insulating substrate (20) having a face side and a back side;
a metal layer (30) connected to the face side of the insulating substrate (20), wherein a semiconductor device (40) can be joined to the metal layer (30);
a stress relaxation member (50) connected to the back side of the insulating substrate (20), wherein the stress relaxation member (50) includes a face side, a back side, and one or more stress relaxation spaces (51; 52), wherein each stress relaxation space (51; 52) includes an opening that is open to at least one of the face side and the back side of the stress relaxation member (50); and
a cooler (60) connected to the back side of the stress relaxation member (50),
the heat dissipation device being **characterized in that**
the stress relaxation member (50) is formed from aluminum with purity greater than or equal to 99.99% by weight,
the insulating substrate (20) and the metal layer (30) are connected with each other by a first brazing filler material (70), the insulating substrate (20) and the stress relaxation member (50) are connected with each other by a second brazing filler material (80), and the stress relaxation member (50) and the cooler (60) are connected with each other by a third brazing filler material (90), and
at least one of the second brazing filler material (80) and the third brazing filler material (90) has one or more through-holes (81, 91), wherein each through-hole (81, 91) includes an opening that is overlapped with the opening of the stress relaxation space or with the opening of a corresponding one of the stress relaxation spaces (51; 52), and an edge of each through-hole opening is located externally to an edge of the corresponding stress relaxation space opening.

2. The heat dissipation device according to claim 1, wherein the stress relaxation space or spaces are through-holes (51) that extend through the stress relaxation member (50) in a thickness direction of the stress relaxation member (50).

3. The heat dissipation device according to claim 1, wherein the stress relaxation space or spaces are recesses (52) and are recessed without extending through the stress relaxation member (50).

4. The heat dissipation device according to any one of claims 1 to 3, further comprising:
a second insulating substrate (100) including a face side and a back side, the second insulating substrate (100) being located at a portion of the cooler (60) different from another portion of the cooler (60) to which the stress relaxation member (50) is connected;
a second metal layer (110) connected to the face side of the second insulating substrate (100), wherein another semiconductor device (120) can be joined to the second metal layer (110); and
a second stress relaxation member (130) connected to the back side of the second insulating substrate (100) and to the cooler (60), the second stress relaxation member (130) including a face side, a back side, and one or more stress relaxation spaces (131), wherein each stress relaxation space (131) of the second stress relaxation member (130) includes an opening that is open to at least one of the face side and the back side of the second stress relaxation member (130), wherein
the second stress relaxation member (130) is formed from aluminum with purity greater than or equal to 99.99% by weight,
the second insulating substrate (100) and the second metal layer (110) are connected with each other by a fourth brazing filler material (140), the second insulating substrate (100) and the second stress relaxation member (130) are connected with each other by a fifth brazing filler material (150), and the second stress relaxation member (130) and the cooler (60) are connected with each other by a sixth brazing filler material (160), and
at least one of the fifth brazing filler material (150) and the sixth brazing filler material (160) has one or more second through-holes (151, 161), wherein each second through-hole (151, 161) includes an opening, and each second through-hole (151, 161) is overlapped with the opening of the second stress relaxation space or a corresponding one of the second stress relaxation spaces (131), and an edge of the opening of each second through-hole (151, 161) is located externally to an edge of the corresponding stress relaxation space opening.

5. A method for manufacturing a heat dissipation device, comprising the steps of:
arranging a metal layer (30), a first brazing filler material (70), an insulating substrate (20), a second brazing filler material (80), a stress relaxation member (50), a third brazing filler material (90), and a cooler (60), wherein the metal layer (30) is arranged on a face side of the insulating substrate (20) via the first brazing filler material (70), the stress relaxation member (50) has one or more stress relaxation spaces (51; 52), wherein each stress relaxation space (51; 52) includes an opening open to at least one of a face side and a back side of the stress relaxation member (50), the stress relaxation member (50) is formed from aluminum with purity greater than or equal to 99.99% by weight, the second brazing filler material (80) is arranged between the face side of the stress relaxation member (50) and the back side of the insulating substrate (20), the third brazing filler material (90) is arranged between the back side of the stress relaxation member (50) and the cooler (60), at least one of the second brazing filler material (80) and the third brazing filler material (90) has one or more through-holes (81, 91), wherein each through-hole (81, 91) of the third brazing filler material (90) includes an opening, and at least one of the second brazing filler material (80) and the third brazing filler material (90) is arranged such that each through-hole opening is overlapped with the opening of the stress relaxation space or with the opening of a corresponding one of the stress relaxation spaces (51; 52), and an edge of each through-hole opening of the third brazing filler material (90) is located externally to an edge of the corresponding stress relaxation space opening; and
connecting the insulating substrate (20), the metal layer (30), the stress relaxation member (50), and the cooler (60), wherein the insulating substrate (20) and the metal layer (30) are connected with each other by melting the first brazing filler material (70), the stress relaxation member (50) and the insulating substrate (20) are connected with each other by melting the second brazing filler material (80), and the stress relaxation member (50) and the cooler (60) are connected with each other by melting the third brazing filler material (90).

6. The method for manufacturing the heat dissipation device according to claim 5, wherein the stress relaxation space or spaces are through-holes (51) that extend through the stress relaxation member (50) in a thickness direction of the stress relaxation member (50).

7. The method for manufacturing the heat dissipation device according to claim 5, wherein the stress relaxation space or spaces are recesses (52) that are recessed without extending through the stress relaxation member (50).

8. The method for manufacturing the heat dissipation device according to any one of claims 4 to 7, wherein the step of arranging further includes a step of arranging the second metal layer (110), the fourth brazing filler material (140), the second insulating substrate (100), the fifth brazing filler material (150), the second stress relaxation member (130), and the sixth brazing filler material (160), wherein the second metal layer (110) is arranged on a face side of the second insulating substrate (100) via the fourth brazing filler material (140), the second stress relaxation member (130) includes one or more stress relaxation spaces (131), wherein each stress relaxation space (131) includes an opening that is open to at least one of a face side and a back side of the second stress relaxation member (130), the stress relaxation member is formed from aluminum with purity greater than or equal to 99.99% by weight, the fifth brazing filler material (150) is arranged between the face side of the second stress relaxation member (130) and the back side of the second insulating substrate (100), the sixth brazing filler material (160) is arranged between the back side of the second stress relaxation member (130) and the cooler (60), at least one of the fifth brazing filler material (150) and the sixth brazing filler material (160) has one or more second through-holes (151, 161), wherein each second through-hole (151, 161) includes an opening that is overlapped with the opening of the stress relaxation space or the opening of a corresponding one of the stress relaxation spaces (131) of the second stress relaxation member (130), at least one of the fifth brazing filler material (150) and the sixth brazing filler material (160) is arranged such that an edge of each second through-hole opening is located externally to an edge of the corresponding stress relaxation space opening of the second stress relaxation member (130), and
the step of connecting further includes a step of connecting the second insulating substrate (100), the second metal layer (110), the second stress relaxation member (130), and the cooler (60), wherein the second insulating substrate (100) and the second metal layer (110) are connected with each other by melting the fourth brazing filler material (140), the second stress relaxation member (130) and the second insulating substrate (100) are connected with each other by melting the fifth brazing filler material (150), and the second stress relaxation member (130) and the cooler (60) are connected with each other by melting the sixth brazing filler material (160).
